# EUROPÄISCHE PATENTSCHRIFT

(11) **EP 1 063 676 B1**
(45) Veröffentlichungstag und Bekanntmachung des Hinweises auf die Patenterteilung: **07.02.2007**
(21) Anmeldenummer: 00111394.3
(22) Anmeldetag: 26.05.2000
(51) Int. Cl.: H01J 37/05, H01J 37/252

(54) **Vorrichtung und Verfahren zur energie- und winkelaufgelösten Elektronenspektroskopie**
Device and procedure for energy and angle selected electron spectroscopy
Dispositif et procédé de spectroscopie électronique à résolution en énergie et angulaire

(30) Priorität: 25.06.1999 DE 19929185
(43) Veröffentlichungstag der Anmeldung: 27.12.2000
(73) Patentinhaber: Staib Instrumente GmbH, 85416 Langenbach (DE)
(72) Erfinder: Staib, Philippe, Dr., 85416 Langenbach (DE)
(74) Vertreter: Hertz, Oliver

(56) Entgegenhaltungen:
- DE-A1- 19 701 192
- US-A- 3 937 957
- PATENT ABSTRACTS OF JAPAN Bd. 007, Nr. 170 (E-189), 27. Juli 1983 (1983-07-27) & JP 58 075754 A (SHIMAZU SEISAKUSHO KK), 7. Mai 1983 (1983-05-07)

## Beschreibung

Die Erfindung betrifft Vorrichtungen und Verfahren zur Abbildung eines aus geladenen Teilchen mit einer bestimmten Energie- und Winkelverteilung bestehenden Teilchenstrahls auf einen Detektor, und ein Spektrometer, insbesondere für Elektronenbeugungsmessungen, mit Energie- und Winkelauflösung.

Bei der Bestrahlung einer Materialprobe mit elektromagnetischer Strahlung oder geladenen Teilchen kann es durch Wechselwirkungsvorgänge in der Probe zur Abstrahlung geladener Teilchen kommen, deren Raum- (oder Winkel-) und Energieverteilung Rückschlüsse auf physikalische oder chemische Vorgänge bei der Wechselwirkung oder auf Merkmale der beteiligten Teilchensorten oder des Wechselwirkungsbereiches zulassen. Auf dieser Grundlage wurden zahlreiche Analyseverfahren, z.B. unter Verwendung von Elektronenbeugungsuntersuchungen oder spektroskopischen Untersuchungen, realisiert.

Ein Problem der bekannten Analyseverfahren ist die gleichzeitige Erfassung der Winkel- und der Energieverteilung eines Teilchenstrahls (z.B. aus Elektronen, Ionen oder Ionengruppen, Atomen oder Atomgruppen). Beispielsweise besteht bei der Untersuchung der Reflexion hochenergetischer Elektronen an einer Probe (RHEED-Verfahren) ein Interesse an energiegefiltert aufgenommenen Beugungsbildern, um elastische und unelastische Streuvorgänge voneinander zu trennen. Die Modellierung der rein elastischen Streuungen erlaubt eine verbesserte Strukturauflösung.

In DE-OS 197 01 192 werden herkömmliche Systeme zur simultanen Orts- und Energieauflösung bei der Elektronenbeugungsuntersuchung erläutert. Bei einer ersten Bauform wird ein Rastermechanismus implementiert, der eine Abtastung von Ausschnitten des Beugungsbildes und deren Energieanalyse erlaubt, jedoch störanfällig und zeitaufwendig ist, so daß insbesondere Echtzeitanalysen, z.B. zur Beobachtung von Oberflächenveränderungen an Festkörpern, nur eingeschränkt oder gar nicht möglich sind. Eine echte simultane Energie- und Winkelauflösung wird erst mit einer zweiten Bauform erreicht, bei der ein Beugungsbild durch Filterpaare oder -tripel (allgemein: Gruppen von Filterelektroden) beobachtet wird. Zwischen den Filterelektroden werden vorbestimmte Abbremsfelder ausgebildet, die beispielsweise von elastisch gestreute Elektronen durchlaufen werden und die inelastisch gestreuten Elektronen reflektieren.

Zur Realisierung der zweiten Bauform werden beispielsweise von Y. Horio in "Jpn. J. Appl. Phys.", Bd. 35, 1996, S. 3559 ff., Filterelektroden in Form von Kugelgittern beschrieben, die jedoch wegen des zwangsläufig kleinen Arbeitsabstandes, der geringen Energieauflösung und einer Anfälligkeit gegenüber Verunreinigungen nachteilig sind. Demgegenüber wurde gemäß DE-OS 197 01 192 (s. Fig. 16) eine Verbesserung durch die Verwendung von Filterelektroden in Form ebener Gitterelektroden 3, 4 und die Kombination derartiger Filterelektroden mit einer Ablenkeinrichtung 1 zur Ausbildung paralleler Elektronenstrahlen erzielt, deren gegenseitige Abstände der Winkelverteilung der Elektronen entsprechen und die auf die Filterelektroden gerichtet sind. Mit dieser Kombination paralleler Elektronenbahnen mit ebenen Filterelektroden können zwar die obengenannten Nachteile der Technik nach Y. Horio in Bezug auf den Arbeitsabstand des Detektors 2 von der Probe, die Empfindlichkeit und die Robustheit der Abbildungseinrichtung überwunden werden. Für Meßaufgaben mit extremen Anforderungen kann die Abbildungsqualität (hochauflösende Elektronenbeugung), bei denen beispielsweise der Abstand von Beugungsmaxima mit hoher Genauigkeit gemessen werden muß, treten jedoch auch bei der Technik mit den ebenen Filterelektroden einschränkende Bildfehler auf.

Die Bildfehler bei der herkömmlichen energieselektiven Abbildung werden insbesondere durch eine inhomogene Streuwinkelfokussierung und durch störende Moiré-Muster an den gitterförmigen Filterelektroden 3, 4 verursacht. Die beschränkte Qualität der Streuwinkelfokussierung führt dazu, daß insbesondere bei größeren Streuwinkeln der Zusammenhang zwischen den Abständen der parallelen Teilstrahlen und der Winkelverteilung der gestreuten Elektronen nicht mehr linear ist. Je nach Anwendungsfall wird dadurch die Bildgröße und/oder die Auflösung der Abbildung beschränkt.

In US-A-3 937 957 wird eine Vorrichtung zur Bestimmung der Energie von geladenen Teilchen beschrieben, die einen Energieanalysator und ein Elektronlinsensystem mit einem Beschleunigungsweg für die geladenen Teilchen aufweist. Das Elektronenlinsensystem ist aus zwei individuellen Linsen zur Erzeugung eines Zwischenbildes zusammengesetzt.

Die Aufgabe der Erfindung ist es, verbesserte Vorrichtungen und Verfahren zur winkel- und energieauflösenden Abbildung eines Teilchenstrahls anzugeben, die sich durch eine erhöhte Abbildungsqualität, insbesondere durch erweiterte Streulichtbilder und/oder höhere Auflösungen bei der Abbildung, auszeichnen. Es ist ferner die Aufgabe der Erfindung, ein entsprechend ausgestattetes Spektrometer und Verfahren zu dessen Betrieb und Verwendung anzugeben.

Diese Aufgaben werden durch eine Vorrichtung, ein Spektrometer und ein Verfahren mit den Merkmalen der Gegenstände von Patentanspruch 1 bzw. 13 gelöst. Vorteilhafte Ausführungsformen der Erfindung ergeben sich aus den abhängigen Ansprüchen.

Ein erster wichtiger Gesichtspunkt der Erfindung besteht in der Ausstattung einer Abbildungseinrichtung zur energie- und winkelselektiven Abbildung geladener Teilchen, z.B. Elektronen, mit einer vorgeschalteten Eintrittsblende oder einem vorgeschalteten, sich quer zum Teilchenstrahl erstreckenden Eintrittsgitter. Das Eintrittsgitter ist von der Ablenkeinrichtung elektrisch getrennt und liegt vorzugsweise aus Massepotential. Es dient der Begrenzung des probenseitig aus der Ablenkeinrichtung austretenden elektrischen Feldes und erlaubt eine bessere Randstrahllenkung. Die Randstrahllenkung bedeutet, daß die Linearität des Zusammenhangs zwischen Streuwinkeln und Abständen der parallelisierten Teilchenbahnen auch bei größeren Streuwinkeln hin zur Bildberandung gewährleistet ist. Gemäß einer ersten Gestaltungsform ist das Eintrittsgitter ein im wesentlichen ebenes, auf der Achse der Ablenkeinrichtung senkrecht stehendes Gitter, das vorzugsweise für die Abbildung größerer Streuwinkelbereiche von bis zu +/- 10° ausgelegt ist. Kommt es hingegen anwendungsabhängig mehr auf die höchste Linearität (minimalste Verzerrung) bei der Abbildung an, so wird gemäß einer zweiten Gestaltungsform des Eintrittsgitters dieses als Kugelgitter ausgebildet. Als Kugelgitter besitzt das Eintrittsgitter die Form eines Kugeloberflächenausschnitts mit einem zugehörigen vorbestimmten Kugelradius.

Ein weiterer wichtiger Gesichtspunkt der Erfindung besteht darin, eine erfindungsgemäße Vorrichtung zur energie- und winkelaufgelösten Abbildung eines Strahls geladener Teilchen auf eine Detektoreinrichtung auf der Basis der obengenannten Kombination aus einer Ablenkeinrichtung zur Erzeugung paralleler und abgebremster Teilchenstrahlen und einer Filtereinrichtung dahingehend weiter zu entwickeln, daß die Filtereinrichtung aus einem einzigen, in Bezug auf die parallelen Teilchenstrahlen senkrecht ausgerichteten Filtergitter besteht. Dies bedeutet, daß zwischen der Ablenkeinrichtung und der Detektoreinrichtung lediglich eine, sich quer zu den Teilchenstrahlen erstreckende Filtergitter-Elektrode angeordnet ist und der Raum zwischen der Ablenkeinrichtung und der Detektoreinrichtung im übrigen frei von weiteren strahlformenden Elektroden ist. Das Filtergitter bildet bei Zusammenwirkung mit der Ablenkeinrichtung einen Gegenfeldanalysator, der beispielsweise bei Elektronenbeugungsuntersuchungen der Filterung inelastisch gestreuter Elektronen dient.

Der Übergang von einer Gruppe von Filterelektroden zu einem einzelnen Filtergitter stellt insbesondere in Zusammenwirkung mit dem vorgeschalteten Eintrittsgitter einen wichtigen Vorteil sowohl in Bezug auf die Vereinfachung des Gesamtaufbaus als auch in Bezug auf die Abbildungsqualität dar. Es wurde vom Erfinder überraschenderweise festgestellt, daß sich mit dem Filtergitter die gleiche hochempfindliche Energieselektivität wie bei der herkömmlichen Abbildungsvorrichtung erreichen läßt, wobei jedoch keine Moire-Muster entstehen und damit die Bildqualität verbessert wird.

Gegenstand der Erfindung ist auch ein Spektrometer, insbesondere ein Elektronenbeugungs- oder Elektronendiffraktions-Spektrometer, das mit der oben beschriebenen Abbildungseinrichtung ausgestattet ist. Bevorzugte Anwendungen eines derartigen Spektrometers liegen bei Elektronendiffraktionsuntersuchungen bei allen üblichen Energien (LEED, MEED, HEED, entsprechend Low-, Medium-, High-Energy- Electron Diffraction), bei energie- und winkelaufgelösten Ionenstreuungsuntersuchungen, bei der Strukturanalyse durch elastische Streuung und i-nelastische Diffusion (z.B. auf der Basis von Kikushi-Linien) oder bei der winkelaufgelösten Elektronenspektroskopie. Der Einsatz der erfindungsgemäßen Abbildungsvorrichtung ist jedoch nicht auf die Verwendung in einem einfachen Beugungsspektrometer beschränkt.

Gegenstand der Erfindung ist ferner ein Verfahren zur Abbildung eines Teilchenstrahls aus geladenen Teilchen mit einer bestimmten Energie- und Winkelverteilung unter Verwendung der erfindungsgemäßen Abbildungsvorrichtung auf einer Detektoreinrichtung, bei dem die Teilchen mit einer Ablenkeinrichtung zu parallelen und abgebremsten Teilchenstrahlen oder -bahnen geformt und auf ein Filtergitter gerichtet werden, das im Zusammenwirken mit der Ablenkeinrichtung energieselektiv Teilchen mit einer Energie oberhalb einer bestimmten Grenzenergie zu einem Detektor durchläßt und Teilchen mit geringeren Energie reflektiert. Gemäß einer bevorzugten Ausführungsform der Erfindung durchlaufen die Teilchen vor Eintritt in die Ablenkeinrichtung einen probenseitigen feldfreien Raum, der mit einem ebenen oder kugelausschnittsförmigen Eintrittsgitter von der Ablenkeinrichtung abgeschirmt ist.

Die Erfindung bietet die Vorteile einer äußerst guten Energieauflösung, die beispielsweise bei 10 keV Elektronenenergie rd. 2 eV beträgt. Ferner werden die Abbildungseigenschaften gegenüber herkömmlichen Vorrichtungen erheblich verbessert, was sich insbesondere in einer Reduzierung der Verzeichnung bei der Abbildung von Beugungsmaxima äußert. Weitere Vorteile ergeben sich aus dem einfachen Aufbau der erfindungsgemäßen Abbildungsvorrichtung, der Verzerrungsfreiheit der Abbildung (verbesserte Streuwinkelfokussierung) und der Erweiterung der Abbildungsdimensionen (Vergrößerung der auswertbar abbildbaren Streuwinkel).

Weitere Einzelheiten und Vorteile der Erfindung werden im folgenden unter Bezug auf die beigefügten Zeichnungen beschrieben. Es zeigen:
- Fig. 1: eine erste Ausführungsform einer erfindungsgemäßen Abbildungsvorrichtung in schematischer Schnittansicht,
- Fig. 2: eine Illustration der Vorrichtung gemäß Fig. 1 bei vollständiger Reflektion der Teilchenstrahlen,
- Fig. 3: eine Illustration der Fokussierungseigenschaften der Vorrichtung gemäß Fig. 1 bei verschiedenen Streuwinkeln,
- Fig. 4: eine weitere Ausführungsform einer erfindungsgemäßen Abbildungsvorrichtung mit einem ebenen Eintrittsgitter in schematischer Schnittansicht,
- Fig. 5: eine Illustration der Vorrichtung gemäß Fig. 4 bei vollständiger Reflektion der Teilchenstrahlen,
- Fig. 6: eine Illustration der Fokussierungseigenschaften der Vorrichtung gemäß Fig. 5 bei verschiedenen Streuwinkeln,
- Fig. 7: eine weitere Ausführungsform einer erfindungsgemäßen Abbildungsvorrichtung mit einem kugelförmig gekrümmten Eintrittsgitter in schematischer Schnittansicht,
- Fig. 8: eine Illustration der Fokussierungseigenschaften der Vorrichtung gemäß Fig. 7 bei verschiedenen Streuwinkeln,
- Fig. 9: eine weitere Ausführungsform einer erfindungsgemäßen Abbildungsvorrichtung mit einem kugelförmig gekrümmten Eintrittsgitter in schematischer Schnittansicht,
- Fig. 10: eine Illustration der Vorrichtung gemäß Fig. 9 bei vollständiger Reflektion der Teilchenstrahlen,
- Fig. 11: eine Illustration der Fokussierungseigenschaften der Vorrichtung gemäß Fig. 9 bei verschiedenen Streuwinkeln,
- Fig. 12: eine Kurvendarstellung zur Illustration der Verzeichnung als Funktion des Streuwinkels für die in den Fign. 1 bis 11 illustrierten Ausführungsformen der Erfindung,
- Fig. 13: eine Illustration der Energiefilterung eines Beugungsbildes,
- Fig. 14: eine Kurvendarstellung zur Illustration einer Energieverlustmessung an einer Siliziumprobe,
- Fig. 15: eine schematische Übersichtsdarstellung einer RHEED-Apparatur, die mit einem erfindungsgemäßen Spektrometer ausgestattet ist, und

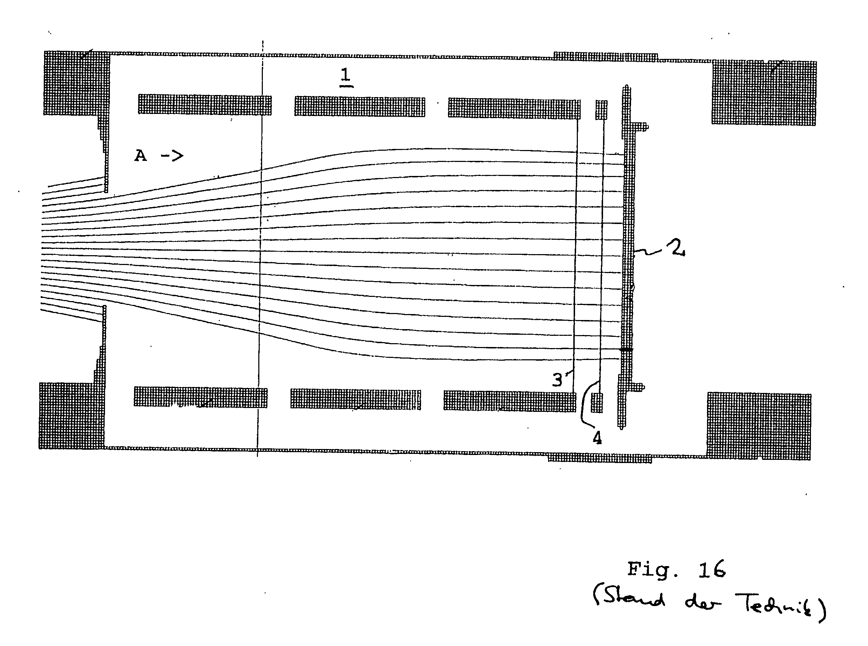

- Fig. 16: eine Schnittansicht einer herkömmlichen Abbildungsvorrichtung für Elektronenstrahlen (Stand der Technik).

Die Erfindung wird im folgenden beispielhaft unter Bezug auf eine Vorrichtung zur Abbildung von Elektronenstrahlen mit einer bestimmten Energie- und Winkelverteilung beschrieben, ist jedoch nicht auf die Abbildung von Elektronen beschränkt, sondern auch bei der Abbildung anderer geladener Teilchen entsprechend anwendbar.

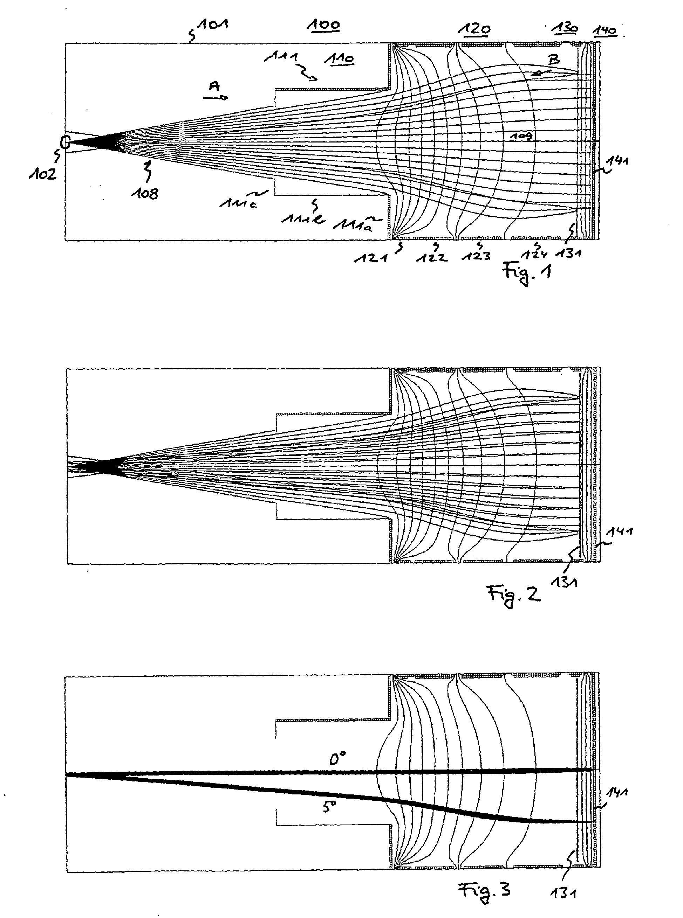

Die Fign. 1 bis 3 zeigen in schematischer Schnittansicht eine erfindungsgemäße Abbildungsvorrichtung 100 zur energie- und winkelauflösenden Abbildung eines Elektronenstrahls 108, wobei aus Übersichtlichkeitsgründen lediglich die in einem Gehäuse 101 untergebrachten Abbildungsstufen gezeigt sind. Die Abbildungsstufen umfassen im einzelnen einen Eintrittsbereich 110, eine Ablenkeinrichtung 120, eine Filtereinrichtung 130 und eine Detektoreinrichtung 140. Das Gehäuse 101 in Form eines geraden Kreiszylinders enthält ferner Halterungsmittel zur Anbringung der genannten Komponenten im Gehäuseinneren, elektrische Anschlußeinrichtungen zur Beaufschlagung der Komponenten mit den gewünschten Steuerspannung und zur Abnahme von Bildsignalen von der Detektoreinrichtung 140 und äußere Halterungen zur Anbringung des Gehäuses 101 beispielsweise an einem Spektrometer. Diese Teile sind jedoch an sich bekannt und daher im einzelnen nicht illustriert. Die geometrischen Dimensionen der Abbildungsvorrichtung 100 werden anwendungsabhängig gewählt und liegen beispielsweise im Bereich von rd. 5 cm bis 15 cm für den Gehäusedurchmesser und dem 0.5 bis 1.5-fachen Gehäusedurchmesser für die axiale Länge der Abbildungsstufen. Die optische Achse der Vorrichtung 100 fällt mit der Zylinderachse des Gehäuses 101 zusammen.

Der Eintrittsbereich 110 wird bei der dargestellten Ausführungsform der Erfindung durch ein Eintrittsfenster 111 in Form einer stufenförmigen Blende gebildet. Das Eintrittsfenster 111 liegt vorzugsweise auf Massepotential, so daß probenseitig vor der Abbildungsvorrichtung 100 ein feldfreier Raum gebildet wird, und dient der Ausblendung von Anteilen des Elektronenstrahls 108 mit großen Streuwinkeln. Es ist beispielsweise eine Ausblendung von Streuwinkeln oberhalb von +/- 6° vorgesehen. Der stufenförmige Aufbau des Eintrittsfensters 111 umfaßt ein axialsymmetrisch angebrachtes Ringblendenteil 111a, ein sich axial erstreckendes, zylinderförmiges Teil 111b und ein an dessen probenseitigen Ende angebrachtes weiteres Ringblendenteil 111c. Der stufenförmige Aufbau erlaubt einen teilweisen Ausgriff der elektrischen Felder der Ablenkeinrichtung 120 auf deren Probenseite.

Die Ablenkeinrichtung 120 umfaßt bei der dargestellten Ausführungsform vier Abbremslinsen 121, 122, 123 und 124. Alternativ können aber auch weniger (mindestens eine) oder mehr Abbremslinsen vorgesehen sein. Die Abbremslinsen sind axialsymmetrisch auf der Innenseite des Gehäuses 101 angebracht und vorzugsweise als Blechringe ausgebildet. Die Dimensionierung und Ansteuerung der Abbremslinsen 121-124 wird anwendungsabhängig gewählt. Es sind entweder für jede Abbremslinse eine separate Anschlußeinrichtung zur Beaufschlagung mit einer variablen Steuerspannung oder für alle Abbremslinsen eine gemeinsame Anschlußeinrichtung und feste Teilerstufen zur Einstellung der Steuerspannungen an den einzelnen Abbremslinsen vorgesehen.

In der Filtereinrichtung 130 ist ausschließlich ein Filtergitter 131 vorgesehen, das im Inneren des Gehäuses 101 zwischen der in Richtung des einfallenden Elektronenstrahls 108 letzten Abbremslinse 124 und der Detektoreinrichtung 140 angebracht ist. Das Filtergitter 131 ist ein ebenes Gitternetz, das sich senkrecht zur Gehäuseachse über den gesamten, durch das Eintrittsfenster 111 und die Abbremslinsen 121-124 gebildeten Einfallsbereich des Elektronenstrahls 108 erstreckt. Das Gitternetz besitzt vorzugsweise eine hohe Transmission von rd. T = 90% und wird durch ein rechteckiges oder schiefwinkliges Streifen- oder Drahtgitter gebildet.

Die Detektoreinrichtung 140 umfaßt einen Leuchtschirm 141, der mit geeigneten Sensormitteln (nicht dargestellt) zusammenwirkt. Die Sensormittel können eine CCD-Kamera, eine Photodiode und/oder einen Elektronenvervielfacher umfassen. Der Leuchtschirm 141 ist zur Vermeidung von elektrischen Aufladungen vorzugsweise mit einem elektrisch leitenden Material aufgebaut. Für sehr empfindliche Messungen mit geringen Strömen kann der Leuchtschirm 141 auch durch einen Channel-Plate-Elektronenvervielfacher ersetzt werden, hinter dem dann ein angepaßter Leuchtschirm angebracht ist.

Im Betriebszustand tritt ein von der schematisch am linken Bildrand in Fig. 1 illustrierten Probe 102 ausgehender Elektronenstrahl 108 durch das Eintrittsfenster 111 in die Ablenkeinrichtung 120 ein. Der Elektronenstrahl 108 ist ein Bündel von Elektronen, die nach Streuung an der Probenoberfläche divergente Teilchenbahnen bilden. In der Darstellung sind die Bahnen durch Linien gezeigt, die jeweils eine Abstufung im Streuwinkel von 1° pro Linie besitzen. Der von dem Eintrittsfenster 111 durchgelassene Ausschnitt der Winkelverteilung für Streuwinkel unterhalb +/- 6° bildet eine Elektronenstromverteilung durch eine auf der Gehäsueachse senkrecht stehende Bezugsebene. Die Elektronen bewegen sich unter dem Einfluß der von den Abbremslinsen 121-124 ausgehenden elektrischen Feldern in Richtung des Pfeiles A, wobei ein Elektronenstrahl 109 mit im wesentlichen parallelen, geraden Teilchenbahnen geformt wird. Dabei werden die Elektronen durch in Strahlrichtung steigende Gegenpotentiale der Abbremslinsen abgebremst. Der Elektronenstrahl 109 bildet eine der ursprünglichen Winkelverteilung entsprechenden Elektronenstromverteilung durch eine Bezugsebene senkrecht zur Bewegungsrichtung A, wobei für große Streuwinkel große Abstände von der Gehäuseachse und für geringe Streuwinkel geringere Abstände von der Gehäuseachse ausgebildet werden.

Die Abbremslinsen erfüllen somit eine Doppelfunktion. Einerseits werden die genannten parallelen Teilchenbahnen (sogenanntes "paralleles Beugungsbild") ausgebildet. Andererseits werden die Elektronen abgebremst, wobei die Abbremsung vorzugsweise so stark ist, daß die Elektronen beim Durchtritt durch die letzte Abbremslinse 124 eine möglichst geringe Energie besitzen. Damit wird eine verbesserte Energieauflösung am Filtergitter 131 erzielt. Es wird beispielsweise eine Abbremsung um rd. 90% angestrebt, wodurch eine rd. 10-fache Verbesserung der Energieauflösung erzielt wird.

Die stationären Potentiale, mit denen die Abbremslinsen 121-124 beaufschlagt werden, können auf der Grundlage der Elektrostatik (z.B. zur Feldverteilung einzelner Linsen) in Abhängigkeit von der konkreten Bauform und der erforderlichen Genauigkeit berechnet oder durch geeignete numerische Simulationen ermittelt werden. Als Eingangsgrößen für die Simulationen dienen insbesondere die Forderungen, daß die Teilchenbahnen nach Durchtritt durch die Ablenkeinrichtung 140 parallel und stark abgebremst verlaufen sollen. Zur Parallelisierung wird beispielsweise eine Divergenz der Teilchenbahnen von weniger als 0.5° als Simulationsbedingung berücksichtigt. Eine weitere Bedingung besteht in der Einstellung einer linearen Winkelabweichung. Dies bedeutet, daß der lineare Zusammenhang zwischen dem Streuwinkel und dem Abstand der jeweiligen Teilchenbahn von der Zylinderachse auch bei großen Streuwinkeln erhalten bleiben soll. Dadurch wird der als Kissenverformung bezeichnete Abbildungsfehler minimiert. Die Ermittlung der Potentiale der Abbremslinsen durch Berechnung oder numerische Simulation erfolgt auch bei den unten erläuterten, abgewandelten Ausführungsformen der Erfindung.

Nach Durchtritt durch die Abbremslinse 123 treffen die Elektronen auf das Filtergitter 131, das mit einer Potentialdifferenz (Filter-Abbremspotential) gegenüber der Abbremslinse 124 zur Bildung eines Abbremsfeldes derart beaufschlagt ist, daß Elektronen mit einer Energie unterhalb einer vorbestimmten Grenzenergie im Teilchenstrahl reflektiert (s. Pfeil B) und nur Teilchen mit einer höheren Energie zur Detektoreinrichtung 140 durchgelassen werden. Die erreichbare Empfindlichkeit der Energieselektivität ist von der Bauform des Filtergitters 131 und den Betriebsparametern, insbesondere der Stärke des Abbremsfeldes und der Größe der Gitteröffnungen (Maschengröße), abhängig. Zur Erzielung einer hohen Abbildungsqualität werden am Filtergitter 131 Gitteröffnungen der Größenordnung 300 µm oder geringer bevorzugt.

Die Elektronen mit einer genügend hohen Energie treten durch die Gitteröffnungen des Filtergitters 131 hindurch und treffen auf den Leuchtschirm 141. Es kann vorgesehen sein, daß zwischen dem Leuchtschirm 141 und dem Filtergitter 131 ein Beschleunigungspotential ausgebildet ist.

Beispielwerte für die Potentiale der Abbremslinsen 121-124 sind jeweils entsprechend -6 kV, -9 kV, -9.4 kV und -10 kV. Das Feldgitter 131 liegt auf einem Potential von -7 kV.

Die in den Fign. 1 und 2 eingezeichneten Elektronenbahnen illustrieren die Filterwirkung der erfindungsgemäßen Abbildungseinrichtung 100. Bei der Darstellung gemäß Fig. 1 besitzen die Elektronen des Elektronenstrahls eine Energie von 10001 eV. Abgesehen von den Teilstrahlen mit hohen Streuwinkeln (+/- 6°), die nicht zu einer fehlerfreien Abbildung beitragen und daher am Filtergitter 131 reflektiert werden, treten sämtliche Elektronen durch das Filtergitter 131 zum Leuchtschirm 141 durch. Besitzen die Elektronen jedoch gemäß Fig. 2 lediglich eine Energie von 9999 eV, so werden alle Elektronen am Filtergitter 131 reflektiert und in die Abbildungsvorrichtung zurückgerichtet. Die Fign. 1 und 2 illustrieren die hervorragende Energieauflösung von rd. 2 eV bei einer Elektronenenergie von rd. 10 keV.

Die Fig. 3 illustriert einen weiteren Vorteil der Erfindung, nämlich die hervorragende Streuwinkelfokussierung, bei verschiedenen Streuwinkeln des Elektronenstrahls von 0° bzw. 5°.
Bei einer Elektronenstrahlausdehnung δx am Probenort wird beispielsweise eine Ausdehnung auf dem Leuchtschirm 141 mit einer Dimension im Bereich von δx/5 bis δx/10 erzielt.

Ein besonderer Vorteil des Filtergitters 131 besteht in der fokussierenden Wirkung der Maschen oder Gitteröffnungen. Durch einen geringfügigen Feldurchgriff durch die Maschen bilden diese jeweils eine kleine elektrooptische Linse. Dieser Fokussierungseffekt wird jedoch nur bei Elektronenenergien von rd. 2 bis 6 eV, d.h. für die bereits abgebremsten, langsamen Elektronen.

Die Fign. 4 bis 6 zeigen eine abgewandelte Ausführungsform der Erfindung. Die Abbildungseinrichtung 100 ist, abgesehen von den Eigenschaften des Eintrittsbereiches 110, im wesentlichen identisch wie die Abbildungsvorrichtung 100 gemäß den Fign. 1 bis 3 aufgebaut. Für die gleichen Komponenten werden daher die gleichen Bezugszeichen verwendet.

Gemäß Fig. 4 ist im Eintrittsbereich 110 ein im wesentlichen ebenes Eintrittsgitter 112 vorgesehen, das sich senkrecht zur Achse des zylinderförmigen Gehäuses 101 erstreckt. Das Eintrittsgitter 112 liegt auf Massepotential, so daß probenseitig vor der Abbildungsvorrichtung 100 ein feldfreier Raum gebildet wird. Das Eintrittsgitter 112 erstreckt sich über den gesamten Einfallsbereich des Elektronenstrahls 108 und ist vorzugsweise wie das Filtergitter 131 als rechteckiges oder schiefwinkliges Streifen- und Drahtnetz ausgebildet. Die geometrische Dimensionierung des Eintrittsgitters 112 wird anwendungsabhängig gewählt. Beispielsweise ergibt sich bei einer großen Maschenweite von rd. 300 µm eine hohe Transmission von rd. 90%, so daß auch schwache Reflexe von der Probe abgebildet werden können. Dadurch wird jedoch die Auflösung der Abbildung beschränkt. Bei kleineren Maschenweiten von bis zu rd. 50 µm ist die Transmission mit rd. 60% geringer, wobei jedoch die Auflösung der Abbildung sich verbessert.

Das Eintrittsgitter 112 wird vorzugsweise als elektrolytisch geätzte Platte hergestellt. Die Platte ist im wesentlichen eben, so daß das Eintrittsgitter 112 Abweichungen von einer ebenen Ausrichtung von weniger als 1/10 mm über der gesamten Gitterfläche aufweist.

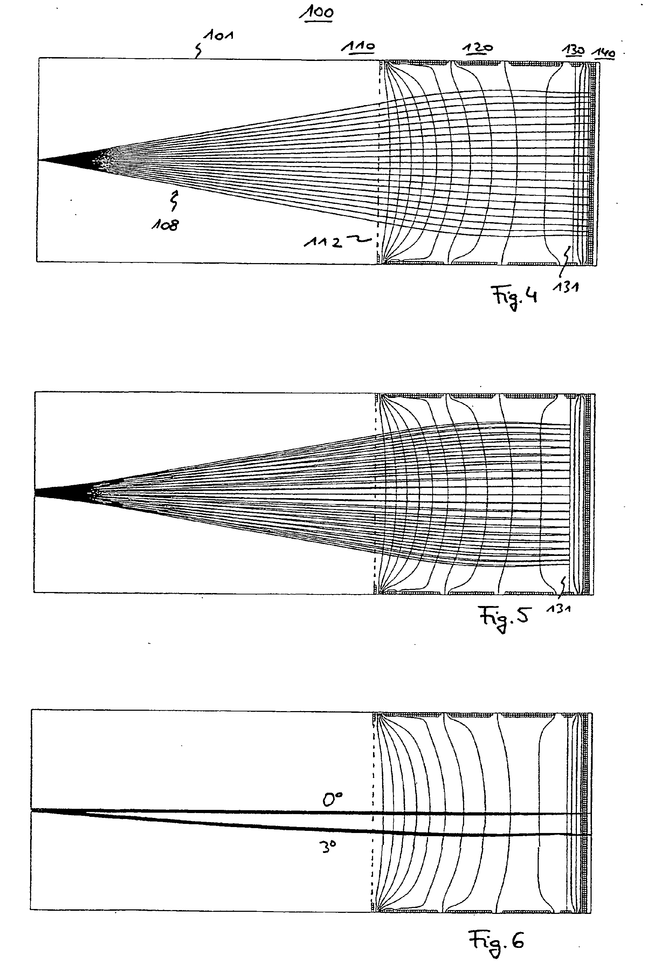

Die Fign. 4 und 5 zeigen analog zu den Fign. 1 und 2 die hohe Energieselektivität der erfindungsgemäßen Abbildungsvorrichtung 100. Elektronen, die von einer mit einer Spannung von -300 V vorgespannten Probe ausgehen, werden mit einer Energie von 10001 eV vom Filtergitter 131 durchgelassen (s. Fig. 4) bzw. mit einer Energie von 9999 eV vom Filtergitter 131 reflektiert (s. Fig. 5).

Fig. 6 illustriert analog zu Fig. 3 die verbesserte Streuwinkelfokussierung an der erfindungsgemäßen Abbildungsvorrichtung 100 für einen Elektronenstrahl mit Streuwinkeln von 0° bzw. 3°. Neben dieser Verbesserung der Abbildungsqualität besteht der Vorteil der Ausführungsform gemäß Fig. 4 in dem erweiterten Winkelbereich bei der Elektronenabbildung. Es können Streuwinkel von bis zu +/- 10° mit hervorragenden Fokussierungseigenschaften abgebildet werden.

Beispielwerte für die Potentiale der Abbremslinsen 121-124 bei der Ausführungsform gemäß den Fign. 4 bis 6 sind jeweils entsprechend -5,5 kV, -7,5 kV, -8,85 kV und -10 kV. Das Filtergitter 131 liegt wiederum bei einem Potential von -7 kV.

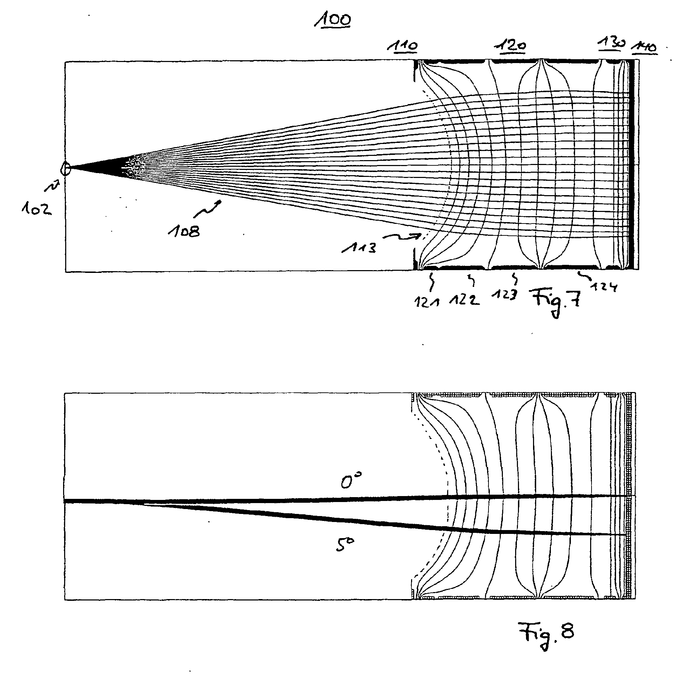

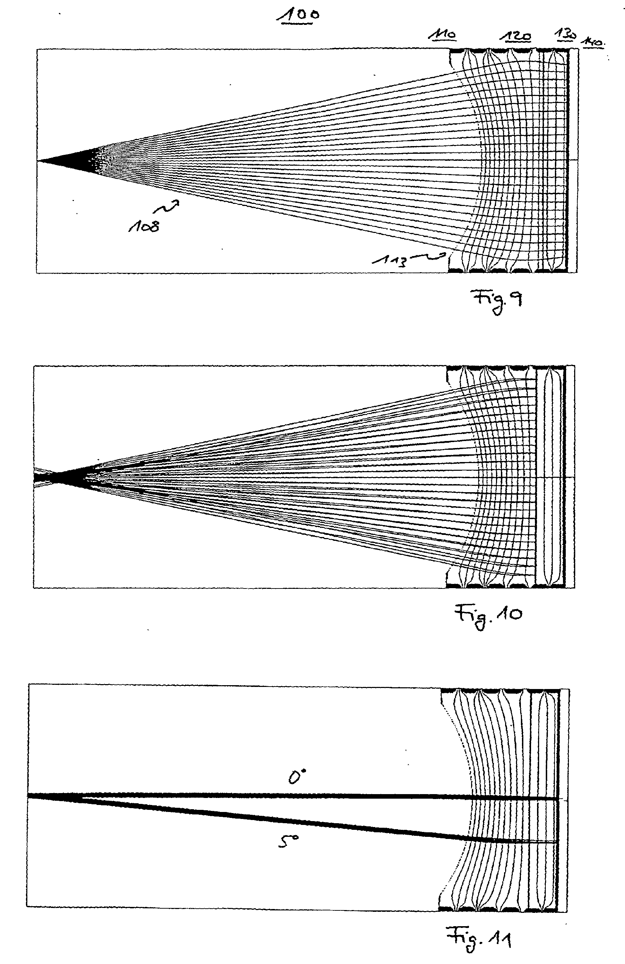

Die Fign. 7 bis 11 illustrieren weitere Abwandlungen einer erfindungsgemäßen Abbildungsvorrichtung 100, bei denen im Eintrittsbereich 110 jeweils ein Kugeleintrittsgitter 113 mit einem geringen Kugelradius für geringere Winkelbereiche (Fign. 7, 8) oder einem größeren Kugelradius für große Winkelbereiche von bis zu +/- 23° (Fign. 9 bis 11) vorgesehen ist. Das Kugelgitter 113 besteht jeweils wie das Eintrittsgitter 112 bei der oben erläuterten Ausführungsform aus einem Gitternetz mit einer anwendungsabhängig gewählten Maschenweite. Es erstreckt sich auf einer Kugeloberfläche mit einem anwendungsabhängig gewählten Kugelradius im Bereich von rd. 50 mm bis 150 mm. Das Kugeleintrittsgitter 113 ist in Bezug auf die optische Achse der Abbildungsvorrichtung 100 axialsymmetrisch angebracht. Der Gitterrand ist über eine ringförmige, in einer senkrecht zur optischen Achse ausgerichteten Bezugsebene liegende Halterung 116 mit dem Gehäuseinneren verbunden. Der senkrechte Abstand der Halterung 116 von der Probe 102 entspricht vorzugsweise dem drei- bis vier-fachen Wert des Radius des Kugeleintrittsgitters 113, kann aber auch geringer sein. Vorteilhafterweise besteht keine empfindliche Abhängigkeit der Abbildungseigenschaften der Abbildungsvorrichtung 100 vom Probenabstand, so daß dieser anwendungsabhängig variieren kann.

Das auf Massepotential liegende Kugeleintrittsgitter 113 bildet probenseitig einen feldfreien Raum und definiert eine erste Äquipotentialfläche der ersten Abbremslinse 121 des Ablenkbereiches 120.

Beispielwerte für die Potentiale der Abbremslinsen 121-124 sind jeweils entsprechend -4 kV, -5 kV, -8,6 kV und -10 kV (Fig. 7) bzw. -3 kV, -7 kV, -8,8 kV und -10 kV (Fig. 9). Die Filtergitter 131 liegen in beiden Fällen bei einem Potential von -7 kV.

Ein Kugeleintrittsgitter wird wie folgt hergestellt. Ein Gitternetz, wie es beispielsweise auch zur Bildung eines ebenen Filtergitters aus einer Platte oder Folie geätzt wird, wird auf eine kugelförmige Form gespannt und auf dieser beispielsweise durch eine Beschichtung versteift. Anschließend wird das nunmehr sich auf einer Kugeloberfläche erstreckende Gitternetz am Rand mit einer geeigneten Halterung zur Anbringung im Gehäuse versehen.

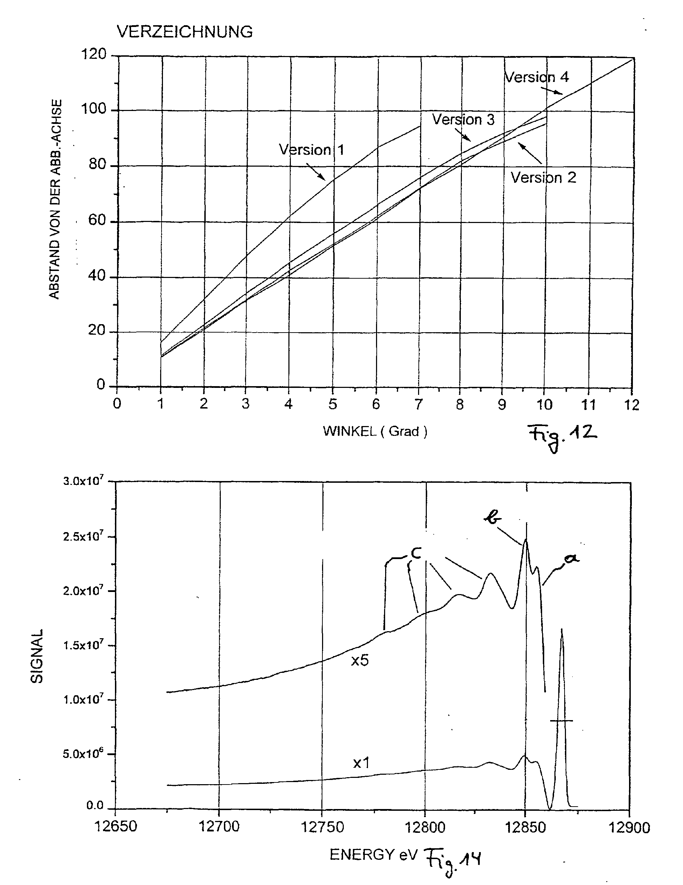

Der Vorteil der Anbringung des Kugeleintrittsgitter 115 besteht in der weiteren Verbesserung der Linearität der Abbildung bei hohen Streuwinkeln. Die Verzerrung wird minimiert und die Streulichtfokussierung wird verbessert. Dies ist in den Fign. 8 bzw. 11 illustriert. Des weiteren wird die Energieselektivität verbessert. So zeigt Fig. 9 den Hindurchtritt von Elektronen mit einer Energie von 10006 eV durch das Filtergitter 131. Bei der entsprechenden Abbildung von Elektronen mit einer geringeren Energie von z. B. 10004 eV werden diese am Filtergitter 131 reflektiert (Fig. 10).

Fig. 12 illustriert die hohe Qualität der Abbildung von Elektronenstrahlen auch bei großen Streuwinkeln. Es ist die Abhängigkeit der Verzeichnung vom Streuwinkel dargestellt. Die mit Version 1 bis Version 4 bezeichneten Kurvenverläufe entsprechen den oben erläuterten Ausführungsformen gemäß den Fig. 1, 4, 7 bzw. 9. Die dargestellten Verzeichnungswerte sind mit gattungsgemäßen Abbildungsvorrichtungen nicht erzielbar.

Bei Elektronenbeugungsuntersuchungen kann erfindungsgemäß zum streifenden Einfall der Elektronenbestrahlung übergegangen werden, so daß sich ein Bestrahlungsfleck in Form einer Ellipse ergibt, die eine Querdimension im Bereich von 300 µm bis 1 mm und eine 5- bis 10-fach größere Längsdimension besitzt. Durch die hervorragende Streuwinkelfokussierung werden alle von einem derartigen Beleuchtungsfleck ausgehenden, parallelen Strahlen auf einen Punkt fokussiert, der wegen der damit erzielten Spot-Schärfe in seiner Lage genau vermessen werden kann.

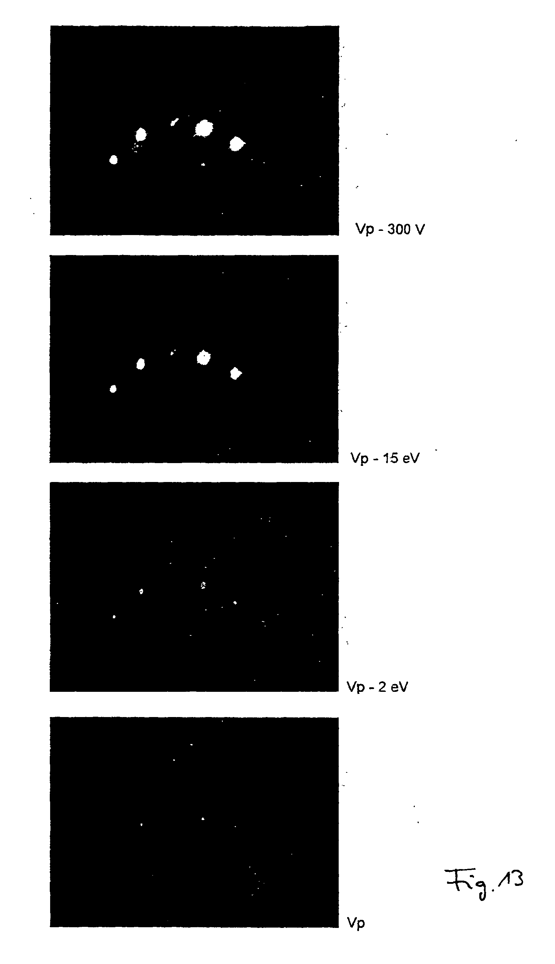

In Fig. 13 ist mit einer Bildfolge die Energiefilterung mit einer erfindungsgemäßen Abbildungsvorrichtung bei der Untersuchung der Elektronenbeugung an einer Siliziumprobe dargestellt. Die (111)-Oberfläche der Siliziumprobe wird unter Einstellung einer Strahlspannung von Vₚ = 15000 V bestrahlt und der gebeugte Elektronenstrahl mit Streuwinkeln von +/- 10° erfaßt. Dies entspricht einem Gesamtgesichtsfeld von 20°. Die vier Einzelbilder zeigen das Beugungsbild bei verschiedenen Abbremspotentialen des Filtergitters 131 (s. oben). Im einzelnen wurden Abbremspotentiale von jeweils entsprechend Vₚ - 300 V, Vₚ - 15 V, Vₚ - 2 V und Vₚ eingestellt. Die Energiefilterung liefert nicht nur eine saubere Trennung der Streureflexe von Hintergrundstrahlen, sondern auch die Möglichkeit einer genaueren Auswertung der Positionen der Streureflexe.

Fig. 14 illustriert eine mit einer erfindungsgemäßen Abbildungsvorrichtung durchgeführte Energieverlustmessung bei der Streuung von Elektronen an der (111)-Oberfläche von Silizium bei einer Temperatur von T = 585°C. Es ist die Abhängigkeit des vom Detektor für einen bestimmten Reflex gelieferten Detektorsignals (willkürliche Einheiten) von der Energie der gestreuten Elektronen. Durch die Variation des Abbremspotentials des Filtergitters 131 gegenüber dem Ablenkbereich 120 kann der Streuanteil für die verschiedenen Energiebereiche aufgenommen werden. Die Kurve x1 zeigt einen elastischen Streupeak mit einer Halbwertsbreite von 3.4 eV. Im Bereich inelastischer Streuungen (Kurve x5) können Anteile von Oberflächenplasmonen (a), Volumenplasmonen (b) und Mehrfachstreuverlusten (c) identifiziert werden.

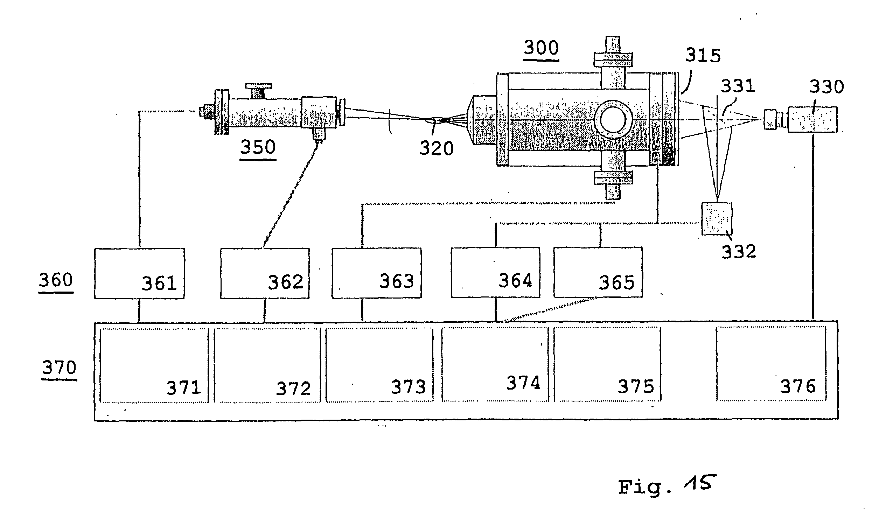

Eine erfindungsgemäße Abbildungsvorrichtung wird vorzugsweise an einem Diffraktionsspektrometer angebracht, das schematisch in Übersichtsdarstellung in Fig. 15 illustriert ist. Fig. 15 zeigt eine RHEED-Apparatur mit einer RHEED-Elektronenstrahlquelle 350, einem erfindungsgemäßen Spektrometer 300, Steuerungselementen 360 und einer Datenverarbeitungseinheit 370. Die Elektronenstrahlquelle 350 ist in an sich bekannter Weise aufgebaut und zur Bestrahlung der Probe 320 vorgesehen. Das gestreute Elektronenbündel wird vom Spektrometer 300 erfaßt, in dem eine Abbildungsvorrichtung gemäß einer der oben erläuterten Ausführungsformen vorgesehen ist. Der Leuchtschirm (hier mit dem Bezugszeichen 315) wird über zwei Meßkanäle simultan beobachtet. Ein Strahlteiler 331 liefert ein Teilbild an eine Bilderfassung mit einem zweidimensionalen Detektor (z.B. einer CCD-Kamera 330) und ein Teilbild an einen schnell ansprechenden, dynamischen Sensor 332 zur Erfassung eines integralen Bildsignals, das die Leuchtdichte des gesamten Beugungsbildes repräsentiert.

Die Steuerungselemente 360 umfassen eine Versorgungseinheit 361 der Elektronenstrahlquelle 350, eine Ablenkeinheit 362 für die Elektronenstrahlquelle 350, eine Spektrometersteuereinheit 360, ein Lock-in-System 364 und einen Stromverstärker 365. Die Datenverarbeitungseinheit 370, die vorzugsweise durch eine Computersteuerung implementiert wird, umfaßt eine Schaltung 371 zur Bereitstellung der Steuersignale für die Versorgungseinheit 361, eine Schaltung 372 zur Vorgabe von Bestrahlungsparametern, eine Schaltung 373 zur Lieferung von Spektrometersteuersignalen, eine Schaltung 374 zur Lock-in-Datenaufnahme, eine Schaltung 375 zur Steuerung von Wachstumsvorgängen mittels einer (nicht dargestellten) MBE-Apparatus und eine Schaltung 376 zur Bildverarbeitung und -anzeige.

Weitere Einzelheiten des Spektrometeraufbaus gemäß Fig. 15 sind an sich aus DE-OS 197 01 192 bekannt, in Bezug auf Einzelheiten des Spektrometers und der Elektrodenansteuerung bei der Elektronenabbildung.

Die erfindungsgemäße energie- und winkelselektive Abbildung geladener Teilchen kann wie folgt modifiziert werden. Abweichend vom oben erläuterten kompakten Aufbau der Abbildungsvorrichtung können in axialer Richtung bzw. Strahlrichtung verlängerte Bauformen realisiert werden, falls beispielsweise die Probe aufgrund ihrer Temperatur oder zur Vermeidung von Verunreinigungen möglichst weit vom Detektor entfernt sein soll. Ferner können innerhalb des Gehäuses zusätzlich Auffangelektroden zur Aufnahme reflektierter oder vom Filtergitter 131 weggelenkter Teile des Elektronenstrahls 108 vorgesehen sein, die die Elektronen, die nicht abgebildet werden sollen, absaugen. Schließlich kann eine erfindungsgemäße Abbildungsvorrichtung mit einer Einrichtung zur Verschiebung des Bildausschnitts versehen sein, wie sie DE-OS 197 01 192 bekannt ist. Eine derartige Einrichtung wird beispielsweise durch eine Ablenk- und Justierspule gebildet und besitzt den Vorteil, daß eine Bildausschnittswahl computergesteuert erfolgen kann, ohne daß eine Verschlechterung des Vakuums im Probenraum erfolgt.

Ein wichtiges Merkmal der Erfindung besteht in der gleichzeitigen Energiefilterung über einem sehr großen Winkelbereich mit stigmatischer Abbildung auf eine sehr große, flache Fokalebene. Diese Fokussierung bleibt erhalten für Teilchen, die nicht nur auf der Achse, sondern über einem größeren Bereich emittiert werden. Diese Eigenschaft ist für Diffraktionsanwendungen sehr wichtig, da im Diffraktionsbereich die Probe mit einem breiteren Elektronenstrahl (1 - 5 mm) bestrahlt wird.

## Patentansprüche

1. Vorrichtung zur Abbildung eines Teilchenstrahls (108), der geladene Teilchen mit einer bestimmten Energie- und Winkelverteilung umfasst, auf einer Detektoreinrichtung (140), wobei die Vorrichtung (100) eine Ablenkeinrichtung (120) mit mindestens einer Abbremslinse (121-124), die dazu vorgesehen ist, im Teilchenstrahl (108) im wesentlichen parallele Teilchenbahnen (109) auszubilden, deren gegenseitigen Abstände der Winkelverteilung der Teilchen entsprechen, und eine Filtereinrichtung (130) umfasst, die zwischen der Ablenkeinrichtung (120) und der Detektoreinrichtung (140) angeordnet ist, wobei die Filtereinrichtung (130) mit einem Potential zur Bildung eines Abbremsfeldes beaufschlagbar und dazu eingerichtet ist, für die Teilchen energieselektiv durchlässig zu sein,
**dadurch gekennzeichnet, dass**
probenseitig vor der Ablenkeinrichtung (120) ein Eintrittsfenster (111) in Form einer axialsymmetrischen Stufenblende oder eines Eintrittsgitter (112, 113) angeordnet ist, das von der Ablenkeinrichtung (120) elektrisch getrennt ist und auf Massepotential liegt.

2. Vorrichtung gemäß Anspruch 1, bei der das Eintrittsgitter ein ebenes Eintrittsgitter (112) ist, das senkrecht zur optischen Achse der Vorrichtung (100) angeordnet ist.

3. Vorrichtung gemäß Anspruch 1, bei der das Eintrittsgitter ein Kugeleintrittsgitter (113) in Gestalt eines Kugeloberflächenausschnitts mit einem vorbestimmten Kugelradius ist.

4. Vorrichtung gemäß Anspruch 3, bei der der Probenabstand zwischen einer Probe (102), von der die geladenen Teilchen ausgehen, und dem Kugeleintrittsgitter (113) dem drei- bis vierfachen Betrag des Kugelradius entspricht.

5. Vorrichtung gemäß einem der Ansprüche 1 bis 4, bei der das Eintrittsgitter (112, 113) Gitteröffnungen mit charakteristischen Dimensionen besitzt, die kleiner oder gleich 300 µm betragen.

6. Vorrichtung gemäß Anspruch 1, bei der die Filtereinrichtung (130) ein Filtergitter (131) umfasst und der Raum von der in Strahlrichtung letzten Abbremslinse (124) der Ablenkeinrichtung (120) bis zur Detektoreinrichtung (140) im übrigen frei von Elektroden zur Teilchenstrahlformung ist.

7. Vorrichtung gemäß Anspruch 6, bei der das Filtergitter (131) so angeordnet ist, dass der Teilchenstrahl (109) mit den parallelen Teilchenbahnen im wesentlichen senkrecht zur Filtergitterebene verläuft.

8. Vorrichtung gemäß Anspruch 6, bei der das Filtergitter (131) Maschengrößen mit charakteristischen Dimensionen umfasst, die kleiner oder gleich 300 µm betragen.

9. Vorrichtung gemäß Anspruch 6, bei der zwischen der in Strahlrichtung letzten Abbremslinse (124) der Ablenkeinrichtung (120) und dem Filtergitter (131) ein Filter-Abbremspotential anliegt, dessen Betrag eine Grenzenergie bestimmt, wobei Teilchen mit einer Energie oberhalb der Grenzenergie das Filtergitter (131) passieren können.

10. Vorrichtung gemäß einem der vorhergehenden Ansprüche, bei der die Detektoreinrichtung (140) einen Abbildungsschirm (141) zur Bildung eines optischen Bildes und Sensormittel zur Erfassung des optischen Bildes umfasst.

11. Vorrichtung gemäß einem der vorhergehenden Ansprüche, bei der die Abbremspotentiale der Abbremslinsen (121-124) und das Filter-Abbremspotential des Filtergitters (131) für die Abbildung von Elektronen, Ionen, Ionengruppen oder geladenen Atom- oder Molekülgruppen ausgebildet sind.

12. Spektrometer, das mit einer Abbildungsvorrichtung (100) gemäß einem der Ansprüche 1 bis 11 ausgestattet ist.

13. Verfahren zur Abbildung eines Teilchenstrahls, der geladene Teilchen mit einer bestimmten Energie- und Winkelverteilung umfasst, mit einer Abbildungsvorrichtung gemäß einem der Ansprüche 1 bis 11 auf der Detektoreinrichtung (140), wobei der Teilchenstrahl (108) die Ablenkeinrichtung (120) mit der mindestens einen Abbremslinse (121-124) zur Ausbildung im wesentlichen paralleler Teilchenbahnen (109) und die Filtereinrichtung (130) durchläuft, die für die Teilchen energieselektiv durchlässig ist, **dadurch gekennzeichnet, dass** der in die Ablenkeinrichtung (120) eintretende Teilchenstrahl (108) durch das Eintrittsfenster (111) in Form einer stufenförmigen Blende begrenzt wird oder durch das probenseitig vor der Ablenkeinrichtung (120) angeordnetes Eintrittsgitter (112, 113), durch das vor der Ablenkeinrichtung (120) ein feldfreier Raum gebildet wird, hindurchtritt.

14. Verfahren gemäß Anspruch 13, bei dem der feldfreie Raum durch ein ebenes oder kugelförmiges Eintrittsgitter (112, 113) begrenzt wird.

15. Verfahren gemäß Anspruch 13, bei dem der Teilchenstrahl (108) in der Filtereinrichtung (130) ein Filtergitter (131) durchläuft, das mit einem Abbremspotential gegenüber der in Strahlrichtung letzten Abbremslinse (124) zur Bildung eines Abbremsfeldes in Bezug auf die Ablenkeinrichtung (120) beaufschlagt wird.

16. Verwendung einer Vorrichtung, eines Spektrometers oder eines Verfahrens gemäß einem der vorhergehenden Ansprüche zur energie- und winkelaufgelösten Abbildung von Elektronen, Ionen, Ionengruppen oder geladenen Atom- oder Molekülgruppen, für Elektronendiffraktionsuntersuchungen, zur Strukturanalyse durch Trennung elastischer und inelastischer Streuungen, und/oder zur winkelaufgelösten Photo- und Auger-Elektronenspektroskopie.

## Claims

1. Device for imaging a particle beam (108), which comprises charged particles having a specific energy and angle distribution, on a detector (140), the device (100) comprising:
- a deflection unit (120) having at least one deceleration lens (121-124) which is provided to form substantially parallel particle trajectories (109) in the particle beam (108), the mutual spacings of said trajectories corresponding to the angle distribution of the particles, and
- a filtering device (130) which is arranged between the deflection unit (120) and the detector (140), the filtering device (130) being capable of being charged with a potential to form a decelerating field and being arranged to be transmissive for the particles in an energy-selective manner,
**characterised in that**
on the sample side upstream of the deflection unit (120) is arranged an entrance window (111) in the form of an axially symmetrical staged aperture or an entrance grid (112, 113) which is electrically separated from the deflection unit (120) and is at earth potential.

2. Device according to claim 1, wherein the entrance grid is a planar entrance grid (112) which is arranged perpendicular to the optical axis of the device (100).

3. Device according to claim 1, wherein the entrance grid is a spherical entrance grid (113) in the shape of a spherical surface cut-out having a predetermined spherical radius.

4. Device according to claim 3, wherein the distance between a sample (102), from which the charged particles are emitted, and the spherical entrance grid (113) corresponds to three to four times the amount of the spherical radius.

5. Device according to one of claims 1 to 4, wherein the entrance grid (112, 113) has grid openings with characteristic dimensions which are smaller than or equal to 300 µm.

6. Device according to claim 1, wherein the filtering device (130) includes a filtering grid (131) and the space from the last deceleration lens (124) of the deflection unit (120) in the beam direction up to the detector (140) is otherwise free of electrodes for particle beam formation.

7. Device according to claim 6, wherein the filtering grid (131) is so arranged that the particle beam (109) with the parallel particle trajectories extends substantially perpendicular to the filtering grid plane.

8. Device according to claim 6, wherein the filtering grid (131) includes mesh sizes with characteristic dimensions which are smaller than or equal to 300 µm.

9. Device according to claim 6, wherein, between the last deceleration lens (124) of the deflection unit in the beam direction and the filtering grid (131), a filter deceleration potential is applied, the amount of which determines an energy cut-off level, particles having an energy above the cut-off energy level being able to pass through the filtering grid (131).

10. Device according to one of the preceding claims, wherein the detector (140) includes an imaging screen (141) for forming an optical image and sensors for capturing the optical image.

11. Device according to one of the preceding claims, wherein the deceleration potentials of the deceleration lenses (121-124) and the filter deceleration potential of the filtering grid (131) are configured for imaging electrons, ions, ion groups or charged atom or molecule groups.

12. Spectrometer which is equipped with an imaging device (100) according to one of claims 1 to 11.

13. Method for imaging a particle beam, which comprises charged particles having a specific energy and angle distribution, by means of an imaging device according to one of claims 1 to 11 on the detector (140), the particle beam (108) passing through the deflection unit (120) having the at least one deceleration lens (121-124) for forming substantially parallel particle trajectories (109) and the filtering device (130) which is transmissive for the particles in an energy-selective manner, **characterised in that** the particle beam (108) entering the deflection unit (120) is limited by the entrance window (111) in the form of a staged aperture or passes through the entrance grid (112, 113), arranged on the sample side upstream of the deflection unit (120), by means of which a field-free space is formed upstream of the deflection unit (120).

14. Method according to claim 13, wherein the field-free space is limited by a planar or spherical entrance grid (112, 113).

15. Method according to claim 13, wherein the particle beam (108) passes in the filtering device (130) through a filtering grid (131) to which a deceleration potential is applied opposite the last deceleration lens (124) in the beam direction for forming a decelerating field with respect to the deflection unit (120).

16. Use of a device, a spectrometer or a method according to one of the preceding claims for energy- and angle-resolved imaging of electrons, ions, ion groups or charged atom or molecule groups, for electron diffraction investigations, for structural analysis by separation of elastic and inelastic scattering and/or for angle-resolved photoelectron and Auger electron spectroscopy.

## Revendications

1. Dispositif pour la représentation optique d'un faisceau électronique (108), comprenant des particules chargées avec une distribution énergétique et angulaire définie, sur un dispositif détecteur (140), ledit dispositif de représentation optique (100) comprenant un dispositif de déviation (120) avec au moins une lentille de freinage (121-124) destinée à séparer le faisceau électronique (108) en pistes de particules (109) sensiblement parallèles, dont les espacements correspondent à la distribution angulaire des particules, et un dispositif de filtrage (130) disposé entre le dispositif de déviation (120) et le dispositif détecteur (140), un potentiel pour la formation d'un champ de freinage étant applicable au dispositif de filtrage (130), lequel est configuré pour être sélectivement perméable aux particules en fonction de leur énergie,
**caractérisé en ce qu'**une fenêtre d'entrée (111) est disposée devant le dispositif de déviation (120) du côté de l'échantillon, sous la forme d'un diaphragme étagé à symétrie axiale ou d'une grille d'entrée (112, 113), électriquement séparée dudit dispositif de déviation (120) et reliée au potentiel de masse.

2. Dispositif selon la revendication 1, où la grille d'entrée est une grille d'entrée plane (112), disposée perpendiculairement à l'axe optique du dispositif (100).

3. Dispositif selon la revendication 1, où la grille d'entrée est une grille d'entrée sphérique (113), sous la forme d'une fraction de surface sphérique à rayon de sphère défini.

4. Dispositif selon la revendication 3, où la distance d'échantillon entre un échantillon (102) d'où partent les particules chargées et la grille d'entrée sphérique (113) représente trois à quatre fois la valeur du rayon de sphère.

5. Dispositif selon l'une des revendications 1 à 4, où la grille d'entrée (112, 113) présente des ouvertures de grille de dimensions caractéristiques, inférieures ou égales à 300 µm.

6. Dispositif selon la revendication 1, où le dispositif de filtrage (130) comprend une grille de filtrage (131) et où l'espace entre la dernière lentille de freinage (124) du dispositif de déviation (120) dans le sens du rayonnement et le dispositif détecteur (140) reste exempt d'électrodes pour la formation de faisceau électronique.

7. Dispositif selon la revendication 6, où la grille de filtrage (131) est disposée de telle manière que le faisceau électronique (109) et les pistes de particules parallèles s'étendent sensiblement perpendiculairement au plan de la grille de filtrage.

8. Dispositif selon la revendication 6, où la grille de filtrage (131) présente des grandeurs de maille de dimensions caractéristiques, inférieures ou égales à 300 µm.

9. Dispositif selon la revendication 6, où un potentiel de freinage de filtrage est appliqué entre la dernière lentille de freinage (124) du dispositif de déviation (120) dans le sens du rayonnement et la grille de filtrage (131), dont la valeur définit une énergie seuil, les particules ayant une énergie supérieure à l'énergie seuil pouvant traverser la grille de filtrage (131).

10. Dispositif selon l'une des revendications précédentes, où le dispositif détecteur (140) comprend un écran de représentation optique (141) pour la formation d'une image optique et des moyens capteurs pour la saisie de l'image optique.

11. Dispositif selon l'une des revendications précédentes, où les potentiels de freinage des lentilles de freinage (121-124) et le potentiels de freinage de filtrage de la grille de filtrage (131) sont adaptés à la représentation optique d'électrons, d'ions, de groupes d'ions, ou de groupes d'atomes ou de molécules chargés.

12. Spectromètre pourvu d'un dispositif de représentation optique (100) selon l'une des revendications 1 à 11.

13. Procédé pour la représentation optique avec un dispositif de représentation optique selon l'une des revendications 1 à 11, d'un faisceau électronique comprenant des particules chargées avec une distribution énergétique et angulaire définie, sur le dispositif détecteur (140), le faisceau électronique (108) traversant le dispositif de déviation (120) avec la ou les lentilles de freinage (121-124) pour la formation de pistes de particules (109) sensiblement parallèles, ainsi que le dispositif de filtrage (130) sélectivement perméable aux particules en fonction de leur énergie,
**caractérisé en ce que** le faisceau électronique (108) entrant dans le dispositif de déviation (120) est limité par la fenêtre d'entrée (111) sous la forme d'un diaphragme étagé, ou traverse la grille d'entrée (112, 113) disposée devant le dispositif de déviation (120) du côté de l'échantillon, par laquelle un espace exempt de champ est formé devant le dispositif de déviation (120).

14. Procédé selon la revendication 13, où l'espace exempt de champ est limité par une grille d'entrée (112, 113) plane ou sphérique.

15. Procédé selon la revendication 13, où le faisceau électronique (108) traverse une grille de filtrage (131) dans le dispositif de filtrage (130), à laquelle est appliqué un potentiel de freinage par rapport à la dernière lentille (124) dans le sens du rayonnement, pour la formation d'un champ de freinage relativement au dispositif de déviation (120).

16. Utilisation d'un dispositif, d'un spectromètre ou d'un procédé selon l'une des revendications précédentes pour la représentation optique à résolution énergétique et angulaire d'électrons, d'ions, de groupes d'ions, ou de groupes d'atomes ou de molécules chargés, pour des analyses de diffraction électronique, pour l'analyse structurelle par séparation de diffusions élastiques et non-élastiques, et/ou pour la spectroscopie de photoélectrons et la spectroscopie électronique selon Auger.
